# EUROPEAN PATENT APPLICATION

(11) **EP 4 794 204 A1**
(43) Date of publication of application: **19.08.2026**
(21) Application number: 24887884.5
(22) Date of filing: 01.11.2024
(51) Int. Cl.: H03M 7/30

(54) **DATA COMPRESSION METHOD AND APPARATUS, AND DATA DECOMPRESSION METHOD AND APPARATUS**

(30) Priority: 09.11.2023 CN 202311489545; 29.03.2024 CN 202410386764
(71) Applicant: Huawei Cloud Computing Technologies Co., Ltd., Gui'an New District, Guizhou 550025 (CN)
(72) Inventor: FENG, Ke, Guiyang, Guizhou 550025 (CN)
(74) Representative: Gill Jennings & Every LLP
(86) International application number: PCT/CN2024/129512
(87) International publication number: WO 2025/098272

(57) **Abstract**

A data compression method and apparatus, and a data decompression method and apparatus are disclosed, and relate to the field of data storage technologies. The data compression method includes: obtaining second data corresponding to first data, and then compressing the second data to obtain compressed data corresponding to the first data. A storage structure of the second data is a tree structure, a bottom-layer node of the tree structure includes a root-child node and a leaf-child node that has an index relationship with the root-child node, and the compressed data includes data indicated by the root-child node and compressed data indicated by the leaf-child node. When data in the tree structure is queried, the query is sequentially performed from data indicated by a root node in the tree structure to data indicated by a child node. In this application, the data indicated by the root-child node is not compressed. Therefore, when a compute device finds a data level indicated by the root-child node in the compressed data, compressed data does not need to be decompressed, thereby improving data query efficiency.

## Description

This application claims priorities to Chinese Patent Application No. 202311489545.9, filed with the China National Intellectual Property Administration on November 9, 2023, and entitled "DATA COMPRESSION METHOD AND COMPUTE DEVICE", and to Chinese Patent Application No. 202410386764.2, filed with the China National Intellectual Property Administration on March 29, 2024, and entitled "DATA COMPRESSION METHOD AND APPARATUS AND DATA DECOMPRESSION METHOD AND APPARATUS", both of which are incorporated herein by reference in their entireties.

### TECHNICAL FIELD

This application relates to the field of data storage technologies, and in particular, to a data compression method and apparatus, and a data decompression method and apparatus.

### BACKGROUND

Data compression technology has become a key technology in fields such as storage nowadays. To improve efficiency of querying compressed data by a storage system, a storage device may construct data as a B-Tree or B+-Tree storage structure for storage, and then compress the data stored in the B-Tree or B+-Tree storage structure. For example, a prefix coding algorithm for compressing a common prefix of data is used, or a general compression algorithm for compressing data as a whole is used. However, in the solution in which the foregoing compression algorithm is used, when specific data needs to be queried, a specific location of the specific data in the compressed data cannot be obtained. Consequently, the specific data can be found only after all the compressed data is decompressed, resulting in low query efficiency.

### SUMMARY

This application provides a data compression method and apparatus, and a data decompression method and apparatus, to resolve a problem that when specific data needs to be queried, a specific location of the specific data in compressed data cannot be obtained, and consequently query efficiency is low because the specific data can be found only after all the compressed data is decompressed.

According to a first aspect, this application provides a data compression method. The data compression method may be applied to a computer system or a compute device that supports the computer system in implementing the data compression method. For example, the compute device is a storage device. Herein, an example in which the compute device performs the data compression method provided in this embodiment is used for description. The data compression method includes: obtaining second data corresponding to first data, and then compressing the second data to obtain compressed data corresponding to the first data. A storage structure of the second data is a tree structure. A bottom-layer node of the tree structure includes a root-child node and a leaf-child node that has an index relationship with the root-child node. The first data includes data indicated by the root-child node and data indicated by the leaf-child node. The compressed data includes the data indicated by the root-child node and compressed data indicated by the leaf-child node.

When the data in the tree structure is queried, the query is sequentially performed from data indicated by a root node in the tree structure to data indicated by a child node. However, in this application, the data indicated by the root-child node is not compressed. Therefore, when a data level indicated by the root-child node in the compressed data is found, compressed data does not need to be decompressed, thereby improving data query efficiency. In addition, the data indicated by the leaf-child node is compressed, so that storage space occupied by the data is reduced, and storage space utilization is improved.

In a possible case, the tree structure may be a B+Tree (B+-Tree).

In a possible case, a data format of the first data is specifically a key-value pair Key-Value, and the data indicated by the leaf-child node is sequentially stored in a storage area of the leaf-child node based on keys.

In this application, the data is sequentially stored based on the keys. This helps determine, based on the data indicated by the root-child node, that to-be-decompressed data belongs to an N^{th} group, and then obtains the to-be-decompressed data by decompressing the N groups, thereby improving data query efficiency.

In a possible case, a storage structure of the first data may be one or more of the following: a tree structure, a hash table, and a skip list.

In a possible implementation, a storage area of the root-child node is used to store first child data that meets a condition, and the storage area of the leaf-child node is used to store second child data that does not meet the condition. The first data includes the first child data and the second child data.

For example, the first child data that meets the condition is determined from the first data, and the first child data is migrated to the storage area of the root-child node. In addition, the second child data that meets the condition is determined from the first data, and the second child data is migrated to the storage area of the leaf-child node.

In this application, data with different attributes is separately allocated, based on the condition, to the storage area corresponding to the root-child node or the storage area corresponding to the leaf-child node. Then, when the second data is compressed, only the data indicated by the root-child node is not compressed, and the data indicated by the leaf-child node is compressed. Therefore, when a data level indicated by the root-child node in the compressed data is found, compressed data does not need to be decompressed, thereby improving data query efficiency. In addition, the data indicated by the leaf-child node is compressed, so that storage space occupied by the data is reduced, and storage space utilization is improved.

In a possible case, the condition indicates that an access metric of the data is greater than or equal to a threshold.

For example, the access metric includes an access count or an access frequency. Then, the first child data may indicate hot data, and the second child data may indicate cold data.

In this application, the hot data and the cold data in the data indicated by the bottom-layer node are determined based on the access metric, and the hot data is migrated to the storage area of the root-child node without being compressed. Then, when the key-value is stored in the storage area of the root-child node, because when the data level indicated by the root-child node in the compressed data is found, compressed data does not need to be decompressed, the key-value may be directly obtained, thereby improving efficiency of querying the hot data.

For example, an access count or an access frequency of each piece of data in the first data is determined from metadata corresponding to the first data, and then the first child data whose access count or access frequency meets the threshold and the second child data whose access count or access frequency does not meet the threshold are determined.

In another possible case, an interval between identifiers of two adjacent pieces of data indicated by the root-child node is K plus 1, and K is an integer greater than or equal to 1.

For example, K may indicate a quantity of pieces of second child data included in one group of second child data, that is, a data volume. The identifier may be a key.

In this application, identifiers of two adjacent pieces of data in the storage area of the root-child node are limited, so that the data in the root-child node can regularly indicate the data in the leaf-child node. Therefore, a speed of locating the data in the leaf-child node based on an index of the data in the root-child node is faster, thereby improving data query efficiency.

For example, K satisfies the following formula: *K*(*K* + *X*) ≥ *N* . X is a constant, and N is a data volume included in one bottom-layer node.

In a possible implementation, a storage area of the bottom-layer node in the compressed data is further used to store a right boundary or left and right boundaries of each group of data indicated by the leaf-child node in the storage area of the leaf-child node. A left boundary of a first group of data indicates a minimum byte length from a start address of the storage area corresponding to the leaf-child node to a location at which the first group of data is stored, and a right boundary of the first group of data indicates a maximum byte length from a start address of the storage area corresponding to the leaf-child node to a location at which the first group of data is stored. The first group of data is any group of data indicated by the leaf-child node.

In a possible case, the minimum byte length and the maximum byte length of the first group of data match keys in the first group of data.

In a possible case, the data indicated by the root-child node indicates a right boundary or left and right boundaries of each group of data.

For example, there is an index relationship between the root-child node and the leaf-child node, and the minimum byte length and the maximum byte length of the first group of data match the keys in the first group of data. Then, a right boundary or left and right boundaries of each group of data in the leaf-child node may be determined based on the data in the root-child node.

In this application, when it is determined, based on the index relationship between the root-child node and the leaf-child node, that the data belongs to an N^{th} group of data, a right boundary or left and right boundaries of the N^{th} group of data may be determined based on the right boundary or the left and right boundaries of each stored group of data. Then, the right boundary or the left and right boundaries of the N^{th} group of data are transferred to a compression engine for decompression. This avoids decompression of an entire bottom-layer node, and reduces a quantity of decompression areas transferred to the compression engine, thereby significantly improving compression efficiency and improving a data query speed.

According to a second aspect, this application provides a data decompression method. The data decompression method may be applied to a computer system or a compute device that supports the computer system in implementing the data decompression method. For example, the compute device is a storage device. Herein, an example in which the compute device performs the data decompression method provided in this embodiment is used for description. The data decompression method includes: obtaining a data decompression request including an identifier of first data, and querying compressed data based on the identifier of the first data; and then determining a target storage area that is in the compressed data and that matches the identifier of the first data, and decompressing data in the target storage area, to obtain the first data. A storage structure of the compressed data is a tree structure, and a bottom-layer node of the tree structure includes a root-child node and a leaf-child node that has an index relationship with the root-child node. The compressed data includes data indicated by the root-child node and compressed data indicated by the leaf-child node, and the target storage area is a storage area of the leaf-child node.

When the data in the tree structure is queried, the query is sequentially performed from data indicated by a root node in the tree structure to data indicated by a child node. However, in this application, the data indicated by the root-child node is not compressed. Therefore, when a data level indicated by the root-child node in the compressed data is found, compressed data does not need to be decompressed, thereby improving data query efficiency. In addition, during data query, a smaller area (a target storage area) in which to-be-queried data is located in the storage area of the leaf-child node may be accurately located based on the root-child node and the index relationship. Then, only compressed data in the smaller area needs to be decompressed, and all data does not need to be decompressed, thereby reducing a data volume of compressed data that needs to be decompressed, and further improving data query efficiency.

In a possible case, a data format of the first data is a key-value pair Key-Value, and the data indicated by the leaf-child node is sequentially stored in a storage area of the leaf-child node based on keys.

In a possible case, the tree structure includes a B-Tree.

In a possible implementation, a storage area of the bottom-layer node in the compressed data is further used to store a right boundary or left and right boundaries of each group of data indicated by the leaf-child node in the storage area of the leaf-child node. A left boundary of a first group of data indicates a minimum byte length from a start address of the storage area corresponding to the leaf-child node to a location at which the first group of data is stored, a right boundary of the first group of data indicates a maximum byte length from a start address of the storage area corresponding to the leaf-child node to a location at which the first group of data is stored, and the first group of data is any group of data indicated by the leaf-child node.

In a possible case, the data indicated by the root-child node indicates a right boundary or left and right boundaries of each group of data.

In a possible implementation, the determining the target storage area that is in the compressed data and that matches the identifier of the first data includes: sequentially performing query from a root node of the compressed data to the bottom-layer node based on the identifier of the first data, and then comparing the identifier of the first data with data in the root-child node, to determine a right boundary or left and right boundaries of a second group of data. The first data or address information of the first data is stored in the storage area of the leaf-child node in the bottom-layer node. The second group of data includes the first data, and the right boundary or the left and right boundaries of the second group of data indicate the target storage area.

In this application, because there is an index relationship between the root-child node and the leaf-child node, a smaller area (that is, the target storage area) in which the first data is located in the storage area of the leaf-child node is accurately located. Then, only compressed data in the smaller area needs to be decompressed, and all data does not need to be decompressed, thereby reducing a data volume of compressed data that needs to be decompressed, and improving data query efficiency.

In a possible implementation, the comparing the identifier of the first data with the data in the root-child node, to determine the right boundary or the left and right boundaries of the second group of data includes: determining a first identifier and/or a second identifier that are/is in identifiers of the data indicated by the root-child node and that meet/meets a first policy with the identifier of the first data; and then determining, from an index relationship, a second group of data in a leaf-child node corresponding to the first identifier and/or the second identifier, and obtaining a right boundary or left and right boundaries of the second group of data in a storage area of the leaf-child node. The first policy indicates that the identifier of the first data is less than the first identifier, or the identifier of the first data is greater than the second identifier, or the identifier of the first data is greater than or equal to the first identifier and less than or equal to the second identifier, and the first identifier is less than the second identifier.

In this application, an identifier indicated by the root-child node is queried based on the identifier of the first data, to determine the first identifier and/or the second identifier. Because there is an index relationship between the root-child node and the leaf-child node, a smaller area (that is, the target storage area) in which the first data is located in the storage area of the leaf-child node is accurately located. Then, only compressed data in the smaller area needs to be decompressed, and all data does not need to be decompressed, thereby reducing a data volume of compressed data that needs to be decompressed, and improving data query efficiency.

In a possible implementation, a storage area of the root-child node is used to store first child data that meets a condition, and the storage area of the leaf-child node is used to store second child data that does not meet the condition. The first data includes the first child data and the second child data.

In a possible case, the condition indicates that an access metric of the data is greater than or equal to a threshold.

For example, the access metric includes an access count or an access frequency, the first child data indicates hot data, and the second child data indicates cold data.

In another possible case, an interval between identifiers of two adjacent pieces of data indicated by the root-child node is K plus 1, and K is an integer greater than or equal to 1.

For example, K satisfies the following formula: *K*(*K* + *X*) ≥ *N* . X is a constant, and N is a data volume included in one bottom-layer node.

For more detailed content of the data decompression method provided in this aspect, refer to the descriptions of the first aspect. Details are not described herein again.

According to a third aspect, this application provides a data compression apparatus. The data compression apparatus is used in a computer system or a compute device that supports the computer system in implementing the data compression method. The data compression apparatus includes modules configured to perform the data compression method according to any one of the first aspect or the optional implementations of the first aspect. The data compression apparatus includes:
an obtaining module, configured to obtain second data corresponding to first data, where a storage structure of the second data is a tree structure, a bottom-layer node of the tree structure includes a root-child node and a leaf-child node that has an index relationship with the root-child node, and the first data includes data indicated by the root-child node and data indicated by the leaf-child node; and
a compression module, configured to compress the second data to obtain compressed data corresponding to the first data, where the compressed data includes the data indicated by the root-child node and compressed data indicated by the leaf-child node.

The data compression apparatus provided in this aspect may include a module configured to perform the method according to any implementation of the first aspect.

According to a fourth aspect, this application provides a data decompression apparatus. The data decompression apparatus is used in a computer system or a compute device that supports the computer system in implementing a data decompression method. The data decompression apparatus includes modules configured to perform the data decompression method according to any one of the first aspect or the optional implementations of the first aspect. The data decompression apparatus includes:
an obtaining module, configured to obtain a data decompression request, where the data decompression request includes an identifier of first data;
a query module, configured to query compressed data based on the identifier of the first data, where a storage structure of the compressed data is a tree structure, a bottom-layer node of the tree structure includes a root-child node and a leaf-child node that has an index relationship with the root-child node, and the compressed data includes data indicated by the root-child node and compressed data indicated by the leaf-child node;
a determining module, configured to determine a target storage area that is in the compressed data and that matches the identifier of the first data, where the target storage area is a storage area of the leaf-child node; and
a decompression module, configured to decompress data in the target storage area, to obtain the first data.

The data decompression apparatus provided in this aspect may include a module configured to perform the method according to any implementation of the second aspect.

According to a fifth aspect, this application provides a compute device. The compute device includes a storage and a processor. The storage is configured to store instructions. The processor executes the instructions to implement the method according to any one of the first aspect or the possible implementations of the first aspect. For more detailed content of the compute device in this aspect, refer to the following descriptions of a storage device or a processing device. Details are not described herein again.

According to a sixth aspect, this application provides a computer-readable storage medium. The storage medium stores a computer program or instructions. When the computer program or the instruction are executed by a compute device, the method according to any one of the first aspect or the optional implementations of the first aspect is implemented.

According to a seventh aspect, this application provides a computer program product. The computing program product includes a computer program or instructions. When the computer program or the instructions are executed by a compute device, the method according to any one of the first aspect or the optional implementations of the first aspect is implemented.

For beneficial effects of the second aspect to the fifth aspect, refer to the descriptions of any one of the first aspect or the implementations of the first aspect. Details are not described herein again. Based on the implementations provided in the foregoing aspects, the implementations in this application may be further combined to provide more implementations.

### BRIEF DESCRIPTION OF DRAWINGS

FIG. 1 is a diagram of a structure of a data storage system according to this application;
FIG. 2 is a schematic flowchart of a data compression method according to this application;
FIG. 3a to FIG. 3c are diagrams of a storage structure of a bottom-layer node of first data and second data according to this application;
FIG. 4 is a diagram 1 of a structure of a B+-Tree constructed based on a HOT according to this application;
FIG. 5 is a diagram 2 of a structure of a B+-Tree constructed based on a HOT according to this application;
FIG. 6 is a diagram of a structure of an IOT according to this application;
FIG. 7 is a schematic flowchart of a data decompression method according to this application;
FIG. 8 is a diagram of a structure of a data compression apparatus according to this application; and
FIG. 9 is a diagram of a structure of a data decompression apparatus according to this application.

### DESCRIPTION OF EMBODIMENTS

In the field of data storage, to improve query efficiency of data, a data indexing manner is usually used to quickly query target data. For example, in a database, a tree structure index is usually used. Because data corresponding to an entire tree structure usually occupies large storage space, the data corresponding to the tree structure may be compressed by using a data compression technology, to reduce occupation of storage space. However, before the compressed data is queried or used, the compressed data needs to be decompressed, resulting in a device performance loss.

To reduce the device performance loss caused by decompression of the compressed data before the compressed data is queried or used, the following provides two possible processing solutions.

Processing solution 1: Compress data by using lightweight data encoding. The lightweight data encoding may include prefix encoding (which may also be referred to as a prefix encoding algorithm), run length encoding (run length encoding, RLE), suffix encoding, and the like.

The following uses an example in which data is compressed by using prefix encoding in lightweight data encoding for description. According to order of data in a tree structure, a common prefix of adjacent data is extracted and only one copy of the common prefix is stored, and remaining suffix parts are separately stored, so as to achieve an objective of data compression.

However, when specific data in the compressed data that is obtained by using the prefix encoding is queried, because the compressed data is divided into a common prefix and a suffix part, and the data is incomplete, a specific location of the specific data in the compressed data cannot be determined. Therefore, all the compressed data needs to be decompressed before the query, to obtain the specific data. Consequently, efficiency of querying for the specific data is low. The decompressing all the compressed data means splicing the common prefix and the suffix part to obtain complete data.

In the foregoing solution, when efficiency of querying compressed data is low, because a ratio of a common prefix to a suffix part of the data changes based on a similarity between the data, a compression ratio of the data is unstable. In other words, the compression ratio of the data is directly associated with distribution of the data.

Processing solution 2: Compress data by using a general compression algorithm. The general compression algorithm may include LZ77 (Lempel-Ziv 77).

LZ77 usually compresses all data within a single node in the tree structure index. Compared with Processing solution 1, the general compression algorithm can provide a more stable compression ratio, thereby significantly reducing storage space occupied by compressed data, and reducing storage costs.

However, when specific data in the compressed data obtained by using LZ77 is queried, a specific location of the specific data in the compressed data still cannot be obtained. Then, the specific data can be found only after data in the entire index node is decompressed. Consequently, efficiency of querying for the specific data is low.

Based on Processing solution 2, the data in the tree structure index is selectively compressed by using the general compression algorithm. For example, data in a relatively inactive index node is compressed, and data in a relatively active index node is not compressed.

However, when the specific data to be queried is located in the relatively inactive index node, the data in the entire relatively inactive index node is still decompressed, so that the specific data can be found. Consequently, efficiency of querying for the specific data is low.

Based on this, this application provides a data processing method. In the method, data is compressed data, a storage structure of the compressed data is a tree structure, a bottom-layer node of the tree structure includes a root-child node and a leaf-child node that has an index relationship with the root-child node, and the compressed data includes data indicated by the root-child node and compressed data indicated by the leaf-child node. The method includes: compressing data to obtain the compressed data. Alternatively, the method includes: decompressing the compressed data, to obtain data indicated by a data decompression request.

For example, the data processing method is a data compression method. The data compression method includes: obtaining second data corresponding to first data, and then compressing the second data to obtain compressed data corresponding to the first data. A storage structure of the second data is consistent with the storage structure of the compressed data. The first data includes the data indicated by the root-child node and the data indicated by the leaf-child node.

For another example, the data processing method is a data decompression method. The data decompression method includes: obtaining a data decompression request including an identifier of first data, and querying decompressed data based on the identifier of the first data. Then, a target storage area that is in compressed data and that matches the identifier of the first data is determined, and data in the target storage area is decompressed, to obtain the first data. The target storage area is a storage area of the leaf-child node.

When the data in the tree structure is queried, the query is sequentially performed from data indicated by a root node in the tree structure to data indicated by a child node. However, in this application, the data indicated by the root-child node is not compressed. Therefore, when a data level indicated by the root-child node in the compressed data is found, compressed data does not need to be decompressed, thereby improving data query efficiency. In addition, during data query, a smaller area (a target storage area) in which to-be-queried data is located in the storage area of the leaf-child node may be accurately located based on the root-child node and the index relationship. Then, only compressed data in the smaller area needs to be decompressed, and all data does not need to be decompressed, thereby reducing a data volume of compressed data that needs to be decompressed, and further improving data query efficiency.

Terms used in embodiments of this application are only used to explain specific embodiments of this application, but are not intended to limit this application. The following first briefly describes some concepts that may be used in this application.

B-Tree (B-Tree): is a m-ary balanced tree, and a storage area corresponding to the B-Tree stores an ordered set of a group of keys. The B-Tree includes a plurality of index nodes. The plurality of index nodes may be divided into at least two layers, and each index node stores a plurality of keys. When data in the B-Tree is queried, binary search is performed layer by layer starting from a top-layer index node of the B-Tree based on a given key, until a bottom-layer index node is found.

B+-Tree: A difference between B+-Tree and B-Tree lies in that in the B+-Tree, all keys are stored only in a bottom-layer index node, and an intermediate index node stores only a key used for indexing.

Index node: is a physical storage unit of data. One B+-Tree and one B-Tree include a plurality of index nodes. The index node is also referred to as an index block or an index page, and has a fixed size, which is usually 8 KB or 16 KB.

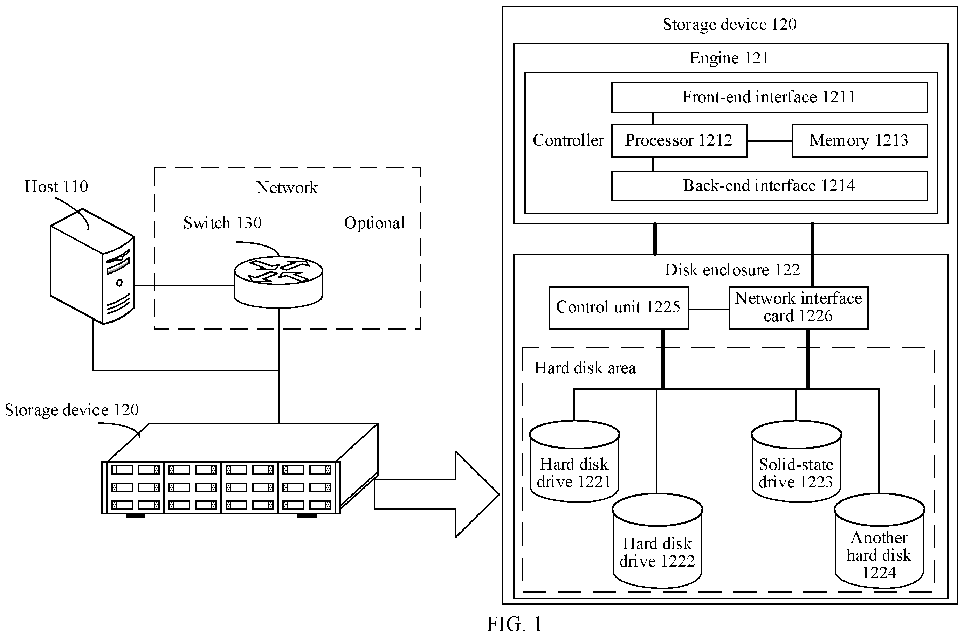

The following describes application scenarios of the data compression method and data decompression method with reference to the accompanying drawings. FIG. 1 is a diagram of a structure of a data storage system according to this application. The data storage system includes a host 110 and a storage device 120. In an application scenario shown in FIG. 1, a user accesses data by using applications. A computer running these applications may be referred to as a "host". The host 110 may be a physical machine, or may be a virtual machine. The physical machine includes but is not limited to a desktop computer, a server, a laptop, and a mobile device.

In a possible example, the host 110 accesses the storage device 120 via a network to access data. For example, the network may include a switch 130.

In another possible example, the host 110 may alternatively communicate with the storage device 120 by using a wired connection, for example, a universal serial bus (universal serial bus, USB) or a peripheral component interconnect express (peripheral component interconnect express, PCIe) bus.

The storage device 120 shown in FIG. 1 may be a centralized storage system. The centralized storage system features a unified portal, and all data from an external device passes through this portal. The portal is an engine 121 of the centralized storage system. The engine 121 is a core component of the centralized storage system, and a large quantity of advanced functions of the storage system are implemented in the engine 121.

As shown in FIG. 1, the engine 121 may include one or more controllers. An example in which the engine 121 includes one controller is used for description in FIG. 1. In a possible example, if the engine 121 includes a plurality of controllers, a mirror channel may exist between any two controllers, to implement a function of mutual backup of any two controllers. This avoids unavailability of the entire storage device 120 caused by a hardware fault. It should be understood as that if the engine 121 includes a plurality of controllers, the engine 121 may also be referred to as an array controller of the storage device 120.

The engine 121 further includes a front-end interface 1211 and a back-end interface 1214. The front-end interface 1211 is configured to communicate with the host 110, to provide a data access service for the host 110. The back-end interface 1214 is configured to communicate with a hard disk, to expand a capacity of the storage device 120. The engine 121 may connect to more hard disks through the back-end interface 1214, to form a large storage resource pool.

In terms of hardware, as shown in FIG. 1, the controller includes at least a processor 1212 and a memory 1213. The processor 1212 is a central processing unit (central processing unit, CPU), configured to process a data access request from outside the storage device 120 (a server or another storage system), and is also configured to process a request generated inside the storage device 120. For example, when receiving, through the front-end interface 1211, data compression requests or data decompression requests sent by the host 110, the processor 1212 temporarily stores data in the data compression requests in the memory 1213. When a total amount of data in the memory 1213 reaches a specific threshold, the processor 1212 sends, to at least one of a hard disk drive 1221, a hard disk drive 1222, a solid-state drive (solid-state drive, SSD) 1223, or another hard disk 1224 through a back-end port, the data stored in the memory 1213, for persistent storage.

The memory 1213 is an internal storage that directly exchanges data with the processor. The memory 1213 can read/write the data at a high speed at any time, and serves as a temporary data storage of an operating system or another running program. The memory includes at least two types of storages. For example, the memory may be a random access memory, or may be a read-only memory (read-only memory, ROM). For example, the random access memory is a DRAM or an SCM. The DRAM is a semiconductor memory, and is a volatile memory (volatile memory) device like most random access memories (random access memory, RAM). However, the DRAM and the SCM are merely examples for description in embodiments. The memory may further include another random access memory, for example, a static random access memory (static random access memory, SRAM). The read-only memory may be, for example, a programmable read-only memory (programmable read-only memory, PROM) or an erasable programmable read-only memory (erasable programmable read-only memory, EPROM).

In addition, the memory 1213 may alternatively be a dual in-line memory module or a dual in-line memory module (dual in-line memory module, DIMM), that is, a module including a dynamic random access memory (DRAM), or may be an SSD. In actual application, a plurality of memories 1213 and different types of memories 1213 may be configured in the controller. A quantity and types of memories 1213 are not limited in embodiments. In addition, the memory 1213 may be configured to have a power protection function. The power protection function means that data stored in the memory 1213 is not lost even when a system is powered off and then powered on again. A memory having the power protection function is referred to as a non-volatile memory.

The memory 1213 stores a software program, and the processor 1212 may write and read compressed data by running the software program in the memory 1213. For example, second compressed data is read from a second address space based on a first address space indicated by a read request and a preset address mapping table, and the second compressed data is decompressed based on compressed information indicated by the read request, to obtain first compressed data.

As shown in FIG. 1, in the system, the engine 121 may not have a hard disk slot, the hard disk needs to be placed in a hard disk enclosure 122, and the back-end interface 1214 communicates with the hard disk enclosure 122. The back-end interface 1214 exists in the engine 121 in a form of an adapter, and one engine 121 may connect to a plurality of disk enclosures through two or more back-end interfaces 1214. Alternatively, an adapter may be integrated in a mainboard. In this case, the adapter may communicate with the processor 1212 through a PCIe bus.

It should be noted that FIG. 1 shows only one engine 121. However, in actual application, the storage system may include two or more engines 121, and redundancy or load balancing is performed among a plurality of engines 121.

The hard disk enclosure 122 includes a control unit 1225 and several hard disks. The control unit 1225 may have a plurality of forms. In one case, the disk enclosure 122 is a smart disk enclosure. As shown in FIG. 1, the control unit 1225 includes a CPU and a memory. The CPU is configured to perform operations such as address translation and data read/write. The memory is configured to temporarily store data that is to be written into the hard disk, or data this is read from the hard disk and that is to be sent to the controller. In another case, the control unit 1225 is a programmable electronic component, for example, a data processing unit (data processing unit, DPU). The DPU has versatility and programmability of the CPU, but is more specialized, and can efficiently run on a network data packet, a storage request, or an analysis request. The DPU is distinguished from the CPU by a high degree of parallelism (which requires processing a large quantity of requests). Optionally, the DPU herein may alternatively be replaced with a processing chip like a graphics processing unit (graphics processing unit, GPU) or an embedded neural-network processing unit (neural-network processing units, NPU). Generally, there may be one control unit 1225 or two or more control units 1225. A function of the control unit 1225 may be offloaded to a network interface card 1226. In other words, in this implementation, the hard disk enclosure 122 does not have a control unit 1225 inside, but the network interface card 1226 completes data read/write, compression, decompression, and another computing function. In this case, the network interface card 1226 is a smart network interface card, and may include a CPU and a memory. The CPU is configured to perform operations such as compression, decompression, and data read/write. The memory is configured to temporarily store data that is to be written into the hard disk, or data this is read from the hard disk and that is to be sent to the controller. The network interface card 1226 may alternatively be a programmable electronic component, for example, a DPU. The network interface card 1226 in the hard disk enclosure 122 does not belong to the hard disk. The network interface card 1226 may access any hard disk (for example, the hard disk drive 1221, the hard disk drive 1222, the solid-state drive 1223, or the another hard disk 1224 shown in FIG. 1) in the hard disk enclosure 122. Therefore, hard disk expansion is convenient when storage space is insufficient.

Based on a type of a communication protocol between the engine 121 and the hard disk enclosure 122, the hard disk enclosure 122 may be a serial attached small computer system interface (serial attached small computer system interface, SAS) hard disk enclosure, may be an non-volatile memory express (Non-Volatile Memory express, NVMe) hard disk enclosure, or may be another type of hard disk enclosure. The SAS disk enclosure uses an SAS 3.0 protocol, and each enclosure supports 25 SAS disks. The engine 121 is connected to the hard disk enclosure 122 through an onboard SAS interface or an SAS interface module. The NVMe disk enclosure is more like a complete computer system, and an NVMe disk is inserted into the NVMe disk enclosure. The NVMe hard disk enclosure is then connected to the engine 121 through an RDMA port.

In an optional implementation, the storage device 120 is a centralized storage system in which a disk and a controller are integrated. The storage device 120 does not have the hard disk enclosure 122. The engine 121 is configured to manage a plurality of hard disks connected through a hard disk slot. A function of the hard disk slot may be implemented by the back-end interface 1214.

In another optional implementation, the storage device 120 shown in FIG. 1 is a distributed storage system. The distributed storage system includes a compute device cluster and a storage device cluster. The compute device cluster includes one or more compute devices, and the compute devices may communicate with each other. The compute device may be a physical compute device, for example, a server, a desktop computer, or a controller of a storage array. In terms of hardware, the compute device may include a processor, a memory, a network interface card, and the like. The processor is a CPU, and is configured to process a data access request from outside the compute device or a request generated inside the compute device. For example, when receiving data write requests sent by a user, the processor temporarily stores data in the data write requests in the memory. When a total amount of data in the memory reaches a specific threshold, the processor sends, to the storage device, the data stored in the memory, for persistent storage. In addition, the processor is further configured to perform calculation or processing on data, for example, metadata management, deduplication, data compression, decompression, virtualized storage space, and address translation. In an example, any compute device may access any storage device in the storage device cluster via a network. The storage device cluster includes a plurality of storage devices. One storage device includes one or more controllers, a network interface card, and a plurality of hard disks. The network interface card is configured to communicate with the compute device.

For example, a storage structure of the data stored in the storage device 120 may be a tree structure, for example, a B-Tree or a B+-Tree.

For example, in the data storage system shown in FIG. 1, the user creates, on the host 110, a compressed file (which may be referred to as first compressed data) in an industry standard format, for example, a joint photographic experts group (Joint Photographic Experts Group, JPEG) file. The storage device 120 compresses the JPEG file by using a preset compression algorithm, to obtain a file in a private format (which may be referred to as second compressed data), and the storage device 120 stores the second compressed data in the storage device. The file in the private format is a format of a file obtained by compressing the JPEG file by the storage device 120 according to a preset compression algorithm. When the user initiates a data decompression request on the host 110, the storage device 120 obtains corresponding second compressed data based on the data decompression request, decompresses the second compressed data to obtain the first compressed data. Finally, the storage device 120 returns the first compressed data to the host 110.

In this application, the storage device 120 may compress and decompress data by using a compression engine in the storage device. The compression engine may be a compression engine that supports a high compression ratio. A function of the compression engine may be implemented by the processor 1212 in the storage device 120. For example, the compression engine may support compression of data by using the general compression algorithm (for example, LZ77) or a lightweight compression algorithm.

The following separately describes how a processing device compresses or decompresses data.

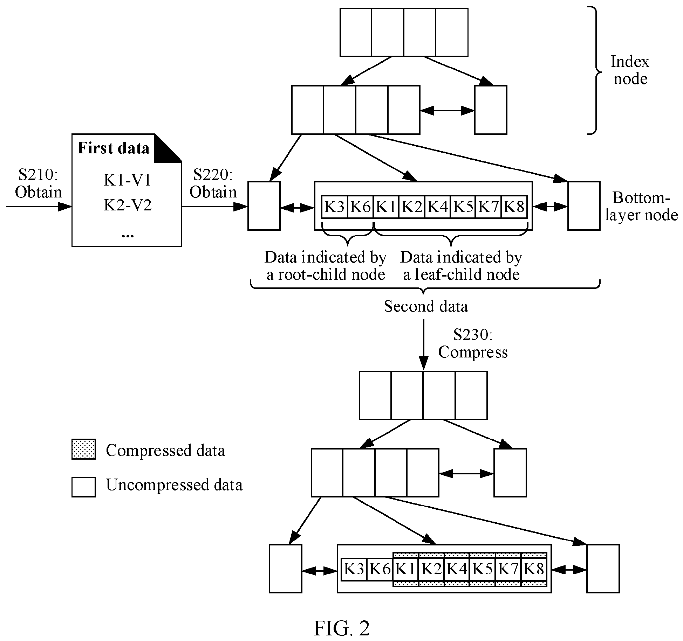

In a first possible scenario, based on the data storage system shown in FIG. 1, a possible implementation of compressing data by a processing device is provided. FIG. 2 is a schematic flowchart of a data compression method according to this application. Content shown in this embodiment may be executed by a processing device 200, and the processing device 200 may be the storage device 120 in FIG. 1. Refer to FIG. 2. The data compression method provided in this embodiment includes step S210 to step S230.

S210: The processing device 200 obtains first data.

A storage structure of the first data may be a tree structure, for example, a B+-Tree or a B-Tree. Data included in each index node in the tree structure is sequentially arranged. For example, the data is sequentially arranged based on values of keys in the data. A data format of the first data may be a key-value pair (Key-Value) form.

In another example of this application, the storage structure of the first data may alternatively be a hash table. In a hash table, a hash function is used to map a key to a bucket (hash bucket), and a key-value pair is stored in the bucket. The hash function can be used to quickly search for and access a specific key-value.

The storage structure of the first data is merely an example provided in this application, and should not be understood as a limitation on this application. In another example in this application, a storage structure that can store data in a key-value format may be the storage structure of the first data, for example, a skip list (skip list). Alternatively, the storage structure of the first data may not be limited, and only a format of the first data needs to be a key-value.

In a possible implementation, that the processing device 200 obtains the first data includes: The processing device 200 obtains the first data from the hard disk drive 1221, the hard disk drive 1222, the solid-state drive 1223, or the another hard disk 1224. In other words, the processing device 200 obtains the first data locally.

For example, the processing device 200 obtains a data compression request a sent by the host 110. The data compression request carries a specific location of the first data in the hard disk, for example, a logical block address (logical block address, LBA). The processing device 200 obtains the first data from the hard disk based on the LBA.

In a possible implementation, that the processing device 200 obtains the first data includes: The processing device 200 obtains the first data sent by the host 110.

For example, the processing device 200 obtains a data compression request forwarded by the host 110 by using the switch 130, where the data compression request carries the first data.

S220: The processing device 200 obtains second data corresponding to the first data.

A storage structure of the second data is a tree structure, and a bottom-layer node of the tree structure includes a root-child node and a leaf-child node that has an index relationship with the root-child node. The first data includes data indicated by the root-child node and data indicated by the leaf-child node.

In a possible case, the tree structure may be a B+-Tree.

As shown in FIG. 2, the storage structure of the second data is a B+-Tree. The B+-Tree includes a plurality of index nodes, and the plurality of index nodes may be divided into at least two layers. Data (Value) corresponding to all keys is stored only in a bottom-layer index node (a bottom-layer node), and only some keys are stored in an intermediate index node.

For example, a storage area corresponding to the bottom-layer node includes storage data corresponding to the root-child node and storage data corresponding to the leaf-child node.

In a possible implementation, that the processing device 200 obtains the second data corresponding to the first data includes: The processing device 200 organizes the storage structure of the first data, to obtain the second data.

For content of that the processing device 200 organizes the storage structure of the first data to obtain the second data, the following provides three possible cases.

In a first possible case, the storage structure of the first data is a B+-Tree.

Because overall storage structures of the first data and the second data are both B+-Trees, the processing device 200 needs to organize only data indicated by the bottom-layer node in the first data, to obtain the second data.

One of a plurality of bottom-layer nodes included in the first data is used as an example for description. The processing device 200 determines, from data indicated by a node a, first child data that meets a condition, and migrates the first child data to the storage area of the root-child node. In addition, the processing device 200 determines, from the data indicated by the node a, second child data that does not meet the condition, and migrates the second child data to the storage area of the leaf-child node.

The first child data is sequentially arranged in the storage area of the root-child node based on keys of the first child data, for example, K3/K6. The second child data is sequentially arranged in the storage area of the leaf-child node based on keys of the second child data, for example, K1/K2/K4/K5/K7/K8.

In this application, the processing device 200 separately allocates, based on the condition, data with different attributes to the storage area corresponding to the root-child node or the storage area corresponding to the leaf-child node. Then, when the second data is compressed, only the data indicated by the root-child node is not compressed, and the data indicated by the leaf-child node is compressed. Therefore, when finding a data level indicated by the root-child node in the compressed data, the processing device 200 does not need to decompress compressed data, thereby improving data query efficiency. In addition, the data indicated by the leaf-child node is compressed, so that storage space occupied by the data is reduced, and storage space utilization is improved.

In a possible example, the condition indicates that an access metric of the data is greater than or equal to a threshold. The access metric includes an access count or an access frequency.

The processing device 200 determines an access count or an access frequency of each piece of data (Key-Value) from metadata of the node a, and then determines the first child data whose access count or access frequency meets the threshold, and the second child data whose access count or access frequency does not meet the threshold.

The first child data may be hot data, the second child data may be cold data, and the access count and the access frequency correspond to different thresholds. For example, the access count corresponds to a threshold a (for example, 50 times), and the access frequency corresponds to a threshold b (for example, 0.2).

For example, the data indicated by the node a includes K (Key) 1-V (Value) 1, K2-V2, K3-V3, K4-V4, and K5-V5. Access counts corresponding to K1-V1, K2-V2, K3-V3, K4-V4, and K5-V5 are respectively 40, 20, 60, 20, and 40. The processing device 200 compares the access counts respectively corresponding to K1-V1, K2-V2, K3-V3, K4-V4, and K5-V5 with the threshold a, and determines that K1-V1, K2-V2, K4-V4, and K5-V5 are second child data, and K3-V3 are first child data. Then, the processing device 300 migrates K2-V2 to the storage area corresponding to the root-child node, and migrates K1-V1, K2-V2, K4-V4, and K5-V5 to the storage area corresponding to the leaf-child node.

It should be noted that second child data located on left and right sides of a key of first child data may be separately used as two groups of second child data. For example, K1-V1 and K2-V2 may be used as a group of second child data, and K4-V4 and K5-V5 may be used as another group of second child data.

In this application, the processing device 200 determines, based on the access metric, hot data and cold data in the data indicated by the bottom-layer node, and migrates the hot data to the storage area of the root-child node without being compressed. Then, when the key-value is stored in the storage area of the root-child node, because the processing device 200 does not need to decompress the compressed data when finding the data level indicated by the root-child node in the compressed data, the key-value may be directly obtained, thereby improving efficiency of querying the hot data by the processing device 200.

In a second possible example, the condition indicates that an interval between identifiers of two adjacent pieces of data indicated by the root-child node is K plus 1, and K is an integer greater than or equal to 1.

K may indicate a quantity of pieces of second child data included in a group of second child data, that is, a data volume. Because data in the bottom-layer node in the first data is sequentially arranged based on keys, each time the processing device 200 determines a group of second child data, the processing device 200 obtains a largest key in the group of second child data, and uses a key-value corresponding to the largest key+1 as the first child data. The identifier is also referred to as a key.

A possible calculation manner is provided below for K. K satisfies the following formula: *K*(*K* + *X*) ≥ *N* . X is a constant, and N is a data volume included in one bottom-layer node.

The constant may be configured by a user, and X is an integer greater than or equal to 1. N is a quantity of key-values included in one bottom-layer node.

For example, K is a minimum positive integer that satisfies the foregoing formula.

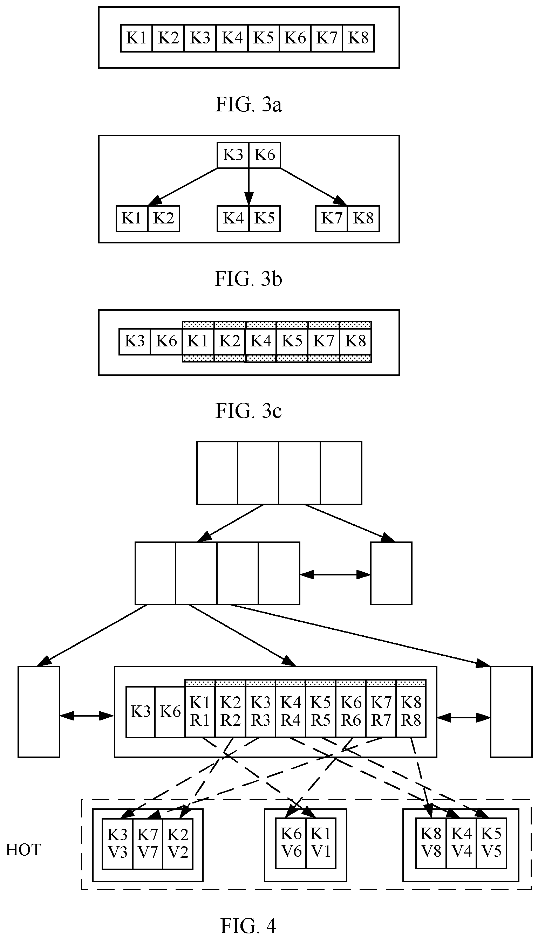

For example, FIG. 3a to FIG. 3c are diagrams of a storage structure of a bottom-layer node of first data and second data according to this application. FIG. 3a to FIG. 3c show a bottom-layer node (a node b) in a plurality of bottom-layer nodes included in the second data. FIG. 3a shows arrangement of data in a bottom-layer node in the first data. In other words, data in the node b in the first data is arranged in ascending order of keys. The processing device 200 receives that X configured by the user is 2, determines that a data volume in the node b is 8, and then determines, according to the foregoing formula, that K is 2.

Then, FIG. 3b shows a logical structure of a root-child node and a leaf-child node in the second data. The processing device 200 uses data corresponding to K1/K2 as one group of first child data, uses data corresponding to K3 as second child data, uses data corresponding to K4/K5 as another group of first child data, uses data corresponding to K6 as second child data, and uses data corresponding to K7/K8 as still another group of first child data.

Therefore, FIG. 3c shows a storage structure of compressed second data. The processing device 300 migrates the data corresponding to K3 and K6 to the storage area corresponding to the root-child node, and migrates the data corresponding to K1, K2, K3, K4, K7, and K8 to the storage area corresponding to the leaf-child node. In the storage area, the data is sequentially stored based on keys, and the data corresponding to K1, K2, K3, K4, K7, and K8 is compressed.

In this application, the data is sequentially stored based on the keys. This helps the processing device 200 determine, based on the data indicated by the root-child node, that to-be-decompressed data belongs to an N^{th} group, and then obtains the to-be-decompressed data by decompressing the N groups, thereby improving data query efficiency.

It should be noted that, in the content shown in FIG. 3a to FIG. 3c, only K3 and K6 in K3-V3 and K6-V6 are migrated to the storage area corresponding to the root-child node for storage, and complete data of K3-V3 and K6-V6 is still stored in the storage area corresponding to the leaf-child node, which is not shown in the figure. Then, the processing device 200 may use data corresponding to K1, K2, and K3 as one group of first child data, and use data corresponding to K4, K5, and K6 as another group of first child data.

In a second possible case, the storage structure of the first data is a B-Tree.

The processing device 200 converts the storage structure of the first data from the B-Tree to a B+-Tree, and then organizes data indicated by a bottom-layer node in the B+-Tree, to obtain the second data.

Because nodes at layers in the B-Tree each store a key-value, the processing device 200 needs to migrate key-values stored in the nodes at the layers to a bottom-layer node for storage, and only a key used for indexing is reserved in the nodes at the foregoing layers.

For content of that the processing device 200 organizes the data indicated by the bottom-layer node in the B+-Tree, to obtain the second data, refer to the descriptions in the first possible case. Details are not described herein again.

In a third possible case, the storage structure of the first data is a skip list.

The processing device 200 converts the storage structure of the first data from the skip list to a B+-Tree, and then organizes data indicated by a bottom-layer node in the B+-Tree, to obtain the second data.

For example, the processing device 200 reads all data in the skip list, and then stores the read data into the constructed B+-Tree.

For content of that the processing device 200 organizes the data indicated by the bottom-layer node in the B+-Tree, to obtain the second data, refer to the descriptions in the first possible case. Details are not described herein again.

The foregoing content is merely a possible case provided in this application, and should not be understood as a limitation on this application. In another embodiment of this application, the processing device 200 additionally constructs a B+-Tree based on the first data, to index the first data.

S230: The processing device 200 compresses the second data to obtain compressed data corresponding to the first data.

The compressed data includes data indicated by the root-child node and compressed data indicated by the leaf-child node.

In a possible implementation, that the processing device 200 compresses the second data to obtain the compressed data corresponding to the first data includes: The processing device 200 compresses only the data indicated by the leaf-child node in the second data, to obtain the compressed data corresponding to the first data.

The processing device 200 may compress, by using a compression algorithm, the data indicated by the leaf-child node, to obtain the compressed data corresponding to the first data.

For example, the compressed data obtained by using the compression algorithm may support partial decompression. The compression algorithm may be an LZ77 algorithm, and the LZ77 algorithm may implement partial decompression based on a right boundary of data.

In a possible case, the compression algorithm may implement partial decompression based on left and right boundaries of data.

For descriptions of the left boundary or the right boundary, refer to the following content of the storage area of the bottom-layer node. Details are not described herein again.

In a possible embodiment, the storage area of the bottom-layer node in the compressed data is further used to store a right boundary or left and right boundaries of each group of data indicated by the leaf-child node in the storage area of the leaf-child node.

A left boundary of a first group of data indicates a minimum byte length from a start address of the storage area corresponding to the leaf-child node to a location at which the first group of data is stored, a right boundary of the first group of data indicates a maximum byte length from a start address of the storage area corresponding to the leaf-child node to a location at which the first group of data is stored, and the first group of data is any group of data indicated by the leaf-child node.

The minimum byte length and the maximum byte length of the first group of data match keys in the first group of data.

In a possible case, the data indicated by the root-child node indicates a right boundary or left and right boundaries of each group of data.

In a possible example, the storage area of the bottom-layer node stores space (a length) occupied by each piece of data (Key-Value). A right boundary of an N^{th} group of data in a plurality of groups of data in the leaf-child node may be determined based on a sum of space occupied by key-values in first N groups of data, and a left boundary of the N^{th} group of data in the plurality of groups of data in the leaf-child node may be determined based on a sum of space occupied by key-values in first N-1 groups of data.

There is an index relationship between the root-child node and the leaf-child node, and the minimum byte length and the maximum byte length of the first group of data match the keys in the first group of data. Then, the processing device 200 may determine a right boundary or left and right boundaries of each group of data in the leaf-child node based on the data in the root-child node.

For example, the data indicated by the root-child node is data corresponding to K3 and K6. Correspondingly, the data indicated by the leaf-child node includes only three groups of data: K1/K2, K4/K5, and K7/K8. The processing device 200 may determine, based on K3 in the root-child node, a right boundary or left and right boundaries of a first group of data K1/K2 in the leaf-child node; determine, based on K3 and K6 in the root-child node, a right boundary or left and right boundaries of a second group of data K4/K5 in the leaf-child node; and determine, based on K6 in the root-child node, a right boundary or left and right boundaries of a third group of data K7/K8 in the leaf-child node.

It should be noted that the right boundary or the left and right boundaries of the first group of data indicate a right boundary or left and right boundaries before compression of the first group of data.

In this application, when determining, based on the index relationship between the root-child node and the leaf-child node, that the data belongs to the N^{th} group of data, the processing device 200 may determine the right boundary or the left and right boundaries of the N^{th} group of data based on the right boundary or the left and right boundaries of each stored group of data, and then transfer the right boundary or the left and right boundaries of the N^{th} group of data to a compression engine for decompression. This avoids decompression of an entire bottom-layer node, and reduces a quantity of decompression areas transferred to the compression engine, thereby significantly improving decompression efficiency and improving a data query speed.

In a possible embodiment, FIG. 4 is a diagram 1 of a structure of a B+-Tree constructed based on a HOT according to this application. A type of the first data is a heap-organized table (heap-organized table, HOT). The HOT stores the data in an independent heap. Heap logic is a set of a group of data, and each piece of data stored in the heap has a unique address, that is, a data address (row identifier, RID). On the HOT, a B+-Tree may be established based on keys. A bottom-layer node of the B+-Tree includes a plurality of Key-RIDs, and the Key-RIDs are sequentially arranged based on the keys.

Based on content in S220, the processing device 200 divides a bottom-layer node of the B+-Tree into a root-child node and a leaf-child node. Data indicated by the root-child node includes K3 and K6, and data indicated by the leaf-child node includes K1-R (RID) 1, K2-R2, K3-R3, K4-R4, K5-R5, K6-R6, K7-R7, and K8-R8. The data indicated by the leaf-child node is sequentially stored in the storage area corresponding to the leaf-child node based on keys.

The processing device 200 performs overall compression on the data indicated by the leaf-child node, so that obtained compressed data includes the data indicated by the root-child node (K3 and K6) and compressed data (compressed K1-R1, K2-R2, K3-R3, K4-R4, K5-R5, K6-R6, K7-R7, and K8-R8) indicated by the leaf-child node.

In a possible example, the processing device 200 may still store the compressed data in a storage area corresponding to a bottom-layer node. The storage area of the bottom-layer node includes a storage area indicated by the leaf-child node.

In another possible example, the processing device 200 stores the compressed data in another storage area, or stores the root-child node in a storage area other than the storage area of the bottom-layer node.

For content of that the processing device 200 performs overall compression on the data indicated by the leaf-child node, refer to the descriptions of S230. Details are not described herein again.

In a possible case, the processing device 200 compresses data indicated by leaf-child nodes under all bottom-layer nodes in the B+-Tree.

In another possible case, the processing device 200 determines, based on a filter condition, to compress data indicated by leaf-child nodes under some bottom-layer nodes in the B+-Tree.

The filter condition may be that an access count or an access frequency of data in each bottom-layer node is less than or equal to a threshold c. If the access count of data in a bottom-layer node a is 100, which is less than the threshold c (120), the processing device 200 compresses data indicated by a leaf-child node under the bottom-layer node a. If the access count of the data in the bottom-layer node a is 150, which is greater than the threshold c (120), the processing device 200 does not compress the data in the bottom-layer node a.

If the access frequency of the data in a bottom-layer node b is 0.2, which is less than the threshold c (0.4), the processing device 200 compresses data indicated by a leaf-child node under the bottom-layer node b. If the access frequency of the data in the bottom-layer node b is 0.5, which is greater than the threshold c (0.4), the processing device 200 does not compress data in the bottom-layer node b.

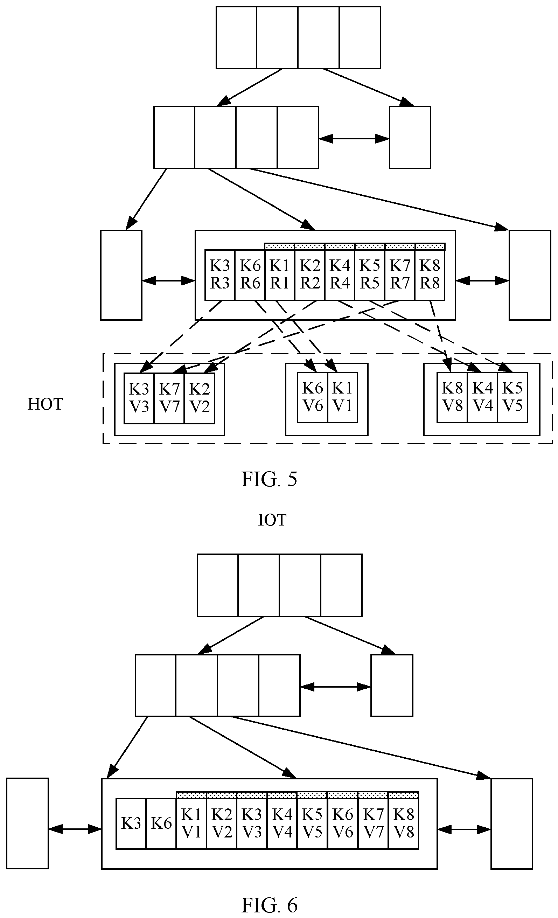

In a possible case, the root-child node in the B+-Tree may store data in a form of a key-value. FIG. 5 is a diagram 2 of a structure of a B+-Tree based on a HOT according to this application. A processing device 200 may divide a bottom-layer node of the B+-Tree into a root-child node and a leaf-child node. Data indicated by the root-child node includes K3-R3 and K6-R6, and data indicated by the leaf-child node includes K1-R1, K2-R2, K4-R4, K5-R5, K7-R7, and K8-R8. The data indicated by the leaf-child node is sequentially stored in a storage area corresponding to the leaf-child node based on keys.

In this application, the processing device 300 stores, in a storage area corresponding to the root-child node, data that occupies small space, such as the RID. When the storage space is not highly occupied, efficiency of querying for the RID indicated in the root-child node can be improved, and then data indicated by the RID can be read, thereby improving efficiency of an entire data query process.

In another possible embodiment, FIG. 6 is a diagram of a structure of an IOT according to this application. A type of the first data is an index-organized table (index-organized table, IOT). The IOT itself is a B+-Tree, and data is directly stored in a bottom-layer node of the B+-Tree. Each bottom-layer node includes a plurality of key-values, and the key-values are sequentially arranged based on keys. Another node of the B+-Tree is used to store only a key used for indexing.

Based on content in S220, the processing device 200 divides a bottom-layer node of the B+-Tree into a root-child node and a leaf-child node. Data indicated by the root-child node includes K3 and K6, and data indicated by the leaf-child node includes K1-V1, K2-V2, K3-V3, K4-V4, K5-V5, K6-V6, K7-V7, and K8-V8. The data indicated by the leaf-child node is sequentially stored in the storage area corresponding to the leaf-child node based on keys.

The processing device 200 performs overall compression on the data indicated by the leaf-child node, so that obtained compressed data includes the data indicated by the root-child node (K3 and K6) and compressed data (compressed K1-V1, K2-V2, K3-V3, K4-V4, K5-V5, K6-V6, K7-V7, and K8-V8) indicated by the leaf-child node. A storage area of the root-child node is used to store only a key of data, to index the data indicated by the leaf-child node.

For more detailed content of this embodiment, refer to the descriptions of the embodiment shown in FIG. 4. Details are not described herein again.

In this application, only the key is stored in the root-child node for indexing. This avoids a case in which a large amount of storage space is occupied because a data volume of the value is large, thereby improving storage space utilization. In addition, all key-values are stored in the storage area of the leaf-child node, and then the data indicated by the leaf-child node is compressed as a whole. This further reduces storage space occupation and improves storage space utilization.

In a possible case, the root-child node in the B+-Tree may store data in a form of a key-value. For example, the processing device 200 may divide a bottom-layer node of the B+-Tree into a root-child node and a leaf-child node. Data indicated by the root-child node includes K3-V3 and K6-V6, and data indicated by the leaf-child node includes K1-V1, K2-V2, K4-V4, K5-V5, K7-V7, and K8-V8. The data indicated by the leaf-child node is sequentially stored in the storage area corresponding to the leaf-child node based on keys.

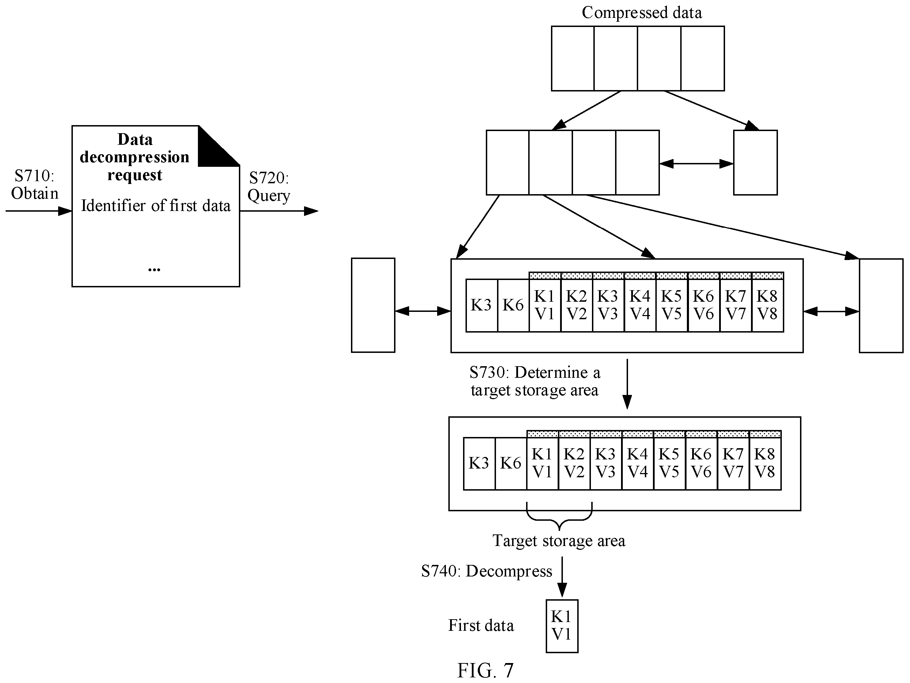

In a second possible scenario, after the processing device 200 compresses the second data to obtain the compressed data, the processing device 200 receives a data decompression request from the host 110, and decompresses a part of data in the compressed data. FIG. 7 is a schematic flowchart of a data decompression method according to this application. Content shown in this embodiment may be executed by a processing device 200, and the processing device 200 may be the storage device 120 in FIG. 1. Refer to FIG. 7. The data decompression method provided in this embodiment includes step S710 to step S740.

S710: The processing device 200 obtains a data decompression request.

The data decompression request includes an identifier of first data. For example, the identifier of the first data is a key of the first data.

In a possible implementation, that the processing device 200 obtains the data decompression request includes: The processing device 200 obtains a data decompression request sent by a host 110.

The data decompression request may be generated by an operation performed by a user on the host 110. For example, the host 110 receives an operation like a tap operation, a slide operation, or a voice operation performed by the user on a front-end display interface of the host 110, and generates the data decompression request.

For example, the host 110 receives that the user taps, on the front-end display interface of the host 110, a control component corresponding to the first data, then determines the identifier of the first data, encapsulates the identifier of the first data into the data decompression request, and sends the data decompression request carrying the identifier of the first data to the processing device 200.

S720: The processing device 200 queries compressed data based on the identifier of the first data.

A storage structure of the compressed data is a tree structure, a bottom-layer node of the tree structure includes a root-child node and a leaf-child node that has an index relationship with the root-child node, and the compressed data includes data indicated by the root-child node and compressed data indicated by the leaf-child node.

For the data indicated by the root-child node and the compressed data indicated by the leaf-child node, refer to content of the data stored in the storage area of the root-child node and the storage area of the leaf-child node shown in FIG. 2. Details are not described herein again.

Because a storage structure of the compressed data is a tree structure, the processing device 200 sequentially performs query, in the compressed data, from data indicated by a root node, to data indicated by a child node. For example, the processing device 200 starts querying from a first-layer index node of the compressed data, and then indexes a second-layer index node based on content found at a first layer; and then queries the second-layer index node, and indexes a third-layer index node based on content found in the second-layer index node. The foregoing steps are repeated until an N^{th} group of data in which the first data is located is queried in the compressed data. N is an integer greater than or equal to 1.

When querying data indicated by the root-child node of the bottom-layer node in the compressed data, the processing device 200 first compares the identifier of the first data with the data in the root-child node, to determine a second group of data to which the first data belongs.

In a possible implementation, the processing device 200 determines a first identifier and/or a second identifier that are/is in identifiers of the data indicated by the root-child node and that meet/meets a first policy with the identifier of the first data, and then determines, from an index relationship, a second group of data in a leaf-child node corresponding to the first identifier and/or the second identifier.

For example, the first policy indicates that the identifier of the first data is less than the first identifier.

In this example, the first identifier is a smallest identifier indicated by the root-child node. For example, the storage area of the root-child node includes K3 and K6, and the first identifier is K3.

For example, FIG. 3b shows a bottom-layer node in the tree structure. In other words, the processing device 200 determines, by using the foregoing query step, that the first data is located in the bottom-layer node shown in FIG. 3b. If the identifier of the first data is K1, the processing device 200 performs binary search in the root-child node, and determines that K1 is less than K3 (the first identifier) in the root-child node. Therefore, it is determined, based on the index relationship between the root-child node and the leaf-child node, that data corresponding to K1 is located in a first group of data indicated by the leaf-child node. The first group of data may also be referred to as data indicated by a first leaf-child node in a plurality of leaf-child nodes.

For another example, the first policy may further indicate that the identifier of the first data is greater than the second identifier.

In this example, the second identifier is a largest identifier indicated by the root-child node. For example, the storage area of the root-child node includes K3 and K6, and the second identifier is K6.

For example, as shown in FIG. 3b, if the identifier of the first data is K7, the processing device 200 performs binary search in the root-child node, and determines that K7 is greater than K6 (the second identifier) in the root-child node. Therefore, it is determined, based on the index relationship between the root-child node and the leaf-child node, that data corresponding to K6 is located in a third group of data indicated by the leaf-child node. The third group of data may also be referred to as data indicated by a third leaf-child node in the plurality of leaf-child nodes.

For another example, the first policy indicates that the identifier of the first data is greater than or equal to the first identifier and less than or equal to the second identifier, and the first identifier is less than the second identifier.

In this example, the first identifier and the second identifier are identifiers that are in the identifiers indicated by the root-child node and that are neighboring to the identifier of the first data, or the first identifier or the second identifier is an identifier that is in the identifiers indicated by the root-child node and that is consistent with the identifier of the first data. For example, the storage area of the root-child node includes K3, K6, and K9. If the identifier of the first data is K5, the first identifier is K3, and the second identifier is K6.

For example, as shown in FIG. 3b, if the identifier of the first data is K5, the processing device 200 performs binary search in the root-child node, and determines that K5 is greater than K3 (the first identifier) in the root-child node, and K5 is less than K6 (the second identifier) in the root-child node. Therefore, it is determined, based on the index relationship between the root-child node and the leaf-child node, that data corresponding to K5 is located in a second group of data indicated by the leaf-child node.

If the identifier of the first data is K6, the processing device 200 performs binary search in the root-child node, and determines that K6 is equal to K6 (the first identifier) in the root-child node. Therefore, it is determined, based on the index relationship between the root-child node and the leaf-child node, that data corresponding to K6 is located in the second group of data indicated by the leaf-child node.

It should be noted that the first group of data, the second group of data, and the like that are indicated by the leaf-child node are sequentially arranged in a data decompression direction. In another example of this application, there may alternatively be another name. This is not limited in this application.

In this application, the processing device 200 queries, based on the identifier of the first data, the identifiers indicated by the root-child node, and then determines the first identifier and/or the second identifier. Because there is an index relationship between the root-child node and the leaf-child node, a smaller area (that is, the target storage area) in which the first data is located in the storage area of the leaf-child node is accurately located. Then, only compressed data in the smaller area needs to be decompressed, and all data does not need to be decompressed, thereby reducing a data volume of compressed data that needs to be decompressed, and improving data query efficiency.

S730: The processing device 200 determines a target storage area that is in the compressed data and that matches the identifier of the first data.

In this embodiment, the target storage area is a storage area of the leaf-child node.

The storage area of the leaf-child node stores the first data or address information of the first data.

The following uses an example in which the first data is stored in the storage area of the leaf-child node for description.

In a possible implementation, that the processing device 200 determines the target storage area that is in the compressed data and that matches the identifier of the first data includes: The processing device 200 determines, from metadata corresponding to the bottom-layer node, the right boundary or the left and right boundaries corresponding to the N^{th} group of data in which the first data is located, to obtain the target storage area that matches the identifier of the first data.

In a possible case, metadata is stored in a storage area of a bottom-layer node of the compressed data, and the metadata may include a right boundary or left and right boundaries of each group of data. The right boundary or the left and right boundaries of each group of data are sequentially stored in the storage area of the bottom-layer node based on arrangement of each group of data. For example, the right boundary or the left and right boundaries of each group of data are arranged in the storage area of the bottom-layer node as follows: the right boundary or the left and right boundaries of the first group of data, the right boundary or the left and right boundaries of the second group of data, and the right boundary or the left and right boundaries of the third group of data.

For example, the processing device 200 obtains an N^{th} right boundary or N^{th} left and right boundaries from the metadata based on the N^{th} group of data in which the first data is located, to obtain the target storage area that matches the identifier of the first data.

In another possible case, the storage area of the bottom-layer node of the compressed data stores space occupied by each group of data, for example, a length, or space occupied by each key-value.

For example, when the storage area of the bottom-layer node of the compressed data stores the space occupied by each group of data, the processing device 200 determines that a length between the right boundary of the first data and a start address a of the storage area corresponding to the leaf-child node is N multiplied by the space occupied by each group of data, and then obtains the right boundary of the first data by adding the start address a to N multiplied by the space occupied by each group of data.

The processing device 200 determines that a length between the left boundary of the first data and the start address a of the storage area corresponding to the leaf-child node is (N-1) multiplied by the space occupied by each group of data, and then obtains the left boundary of the first data by adding the start address a to (N-1) multiplied by the space occupied by each group of data.

For example, when the storage area of the bottom-layer node of the compressed data stores the space occupied by each key-value, the processing device 200 determines that a length between the right boundary of the first data and a start address a of the storage area corresponding to the leaf-child node is N multiplied by a quantity of key-values included in each group of data and then multiplied by the space occupied by each key-value, and then obtains the right boundary of the first data by adding the start address a to the length of the start address a, namely, the N multiplied by the quantity of key-values included in each group of data and then multiplied by the space occupied by each key-value.

The processing device 200 determines that a length from the left boundary of the first data to the start address a of the storage area corresponding to the leaf-child node is (N-1) multiplied by a quantity of key-values included in each group of data and then multiplied by the space occupied by each key-value, and then obtains the left boundary of the first data by adding the first address a to the length of the first address a, namely, (N-1) multiplied by the quantity of key-values included in each group of data and then multiplied by the space occupied by each key-value.

For example, the storage area of the bottom-layer node of the compressed data stores the space occupied by each key-value, and the space occupied by each key-value is inconsistent. The processing device 200 determines that a length from the right boundary of the first data to the start address a of the storage area corresponding to the leaf-child node is a sum of space occupied by key-values in the first N groups of data, and then obtains the right boundary of the first data by adding the start address a to the sum of the space occupied by the key-values in the first N groups of data.

The processing device 200 determines that a length from the left boundary of the first data to the start address a of the storage area corresponding to the leaf-child node is a sum of space occupied by key-values in the first N-1 groups of data, and then obtains the left boundary of the first data by adding the start address a to the sum of the space occupied by the key-values in the first N-1 groups of data.

In a possible example, the metadata is stored at a fixed location in the storage area of the bottom-layer node, for example, located in a start part of the storage area.

For content of that the N^{th} group of data in which the first data is located, refer to the description of S920. Details are not described herein again. For content of the right boundary or the left and right boundaries, refer to the embodiment in which the storage area of the bottom-layer node in the compressed data is further used to store the right boundary or the left and right boundaries. Details are not described herein again.

S740: The processing device 200 decompresses data in the target storage area, to obtain the first data.

The target storage area, that is, the right boundary or the left and right boundaries, is a boundary before data compression.

For content of that the processing device 200 decompresses the data in the target storage area, to obtain the first data, the following provides two possible implementations.

In a first possible implementation, the processing device 200 decompresses the data in the leaf-child node starting from the start address a of the storage area corresponding to the leaf-child node, until the decompressed data reaches the right boundary. The processing device 200 queries, from the decompressed data, for the first data corresponding to the identifier of the first data.

In a second possible implementation, the processing device 200 determines, based on a correspondence between a boundary of data before compression and a boundary of data after compression, a left boundary of data a corresponding to the left boundary of the first data, and then decompresses the compressed data starting from the left boundary of the data a, until the decompressed data reaches the right boundary. The processing device 200 obtains the first data by querying the decompressed data based on the identifier of the first data.

The correspondence between the boundary of the data before compression and the boundary of the data after compression is metadata stored in a bottom-layer node.

For the foregoing content, the following provides a possible example.

As shown in FIG. 6, when the data decompression request received by the processing device 200 carries an identifier K4, the processing device 200 queries the compressed IOT, that is, performs query from a root node of the compressed IOT to a bottom-layer node, and determines that data corresponding to K4 is located in the bottom-layer node a. Then, the processing device 200 queries a root-child node (K3/K6) in the bottom-layer node a based on K4, and determines that K4 is located between K3 and K6, to determine that data corresponding to K4 is located in the second group of data (that is, a second leaf node). The processing device 200 determines, based on space occupied by each key-value maintained in the bottom-layer node, space occupied by key-values in the first two groups of data, to obtain a right boundary of the second group of data. The processing device 200 decompresses the data in the leaf-child node starting from the start address a of the storage area corresponding to the leaf-child node, until the decompressed data reaches the right boundary, and then queries the decompressed data for a value corresponding to K4.

In a possible embodiment, if the storage area of the leaf-child node stores the address information of the first data, that is, the data stored in the leaf-child node is a Key-RID, that the processing device 200 decompresses the data in the target storage area, to obtain the first data includes: The processing device 200 decompresses the data in the leaf-child node starting from the start address a of the storage area corresponding to the leaf-child node, until the decompressed data reaches the right boundary. The processing device 200 queries for the identifier of the first data from the decompressed data, to query for a corresponding RID of the first data, and then reads the value indicated by the RID.

Alternatively, the processing device 200 determines, based on a correspondence between a boundary of data before compression and a boundary of data after compression, a left boundary of data a corresponding to the left boundary of the first data, and then decompresses the compressed data from the left boundary of the data a, until the decompressed data reaches the right boundary. The processing device 200 queries for the identifier of the first data from the decompressed data, to query for a corresponding RID of the first data, and then reads the value indicated by the RID.

In a possible embodiment, the data is stored in the storage area of the root-child node in a form of a key-value. Then, after the processing device 200 finds that the data in the root-child node matches the identifier of the first data, the matched data may be directly returned.

It may be understood that, to implement functions in the foregoing embodiments, the processing device includes corresponding hardware structures and/or software modules for performing the functions. A person skilled in the art should be easily aware that, the units and method steps in the examples described with reference to embodiments disclosed in this application can be implemented by hardware or a combination of hardware and computer software. Whether a function is performed by hardware or hardware driven by computer software depends on specific application scenarios and design constraint conditions of the technical solutions.

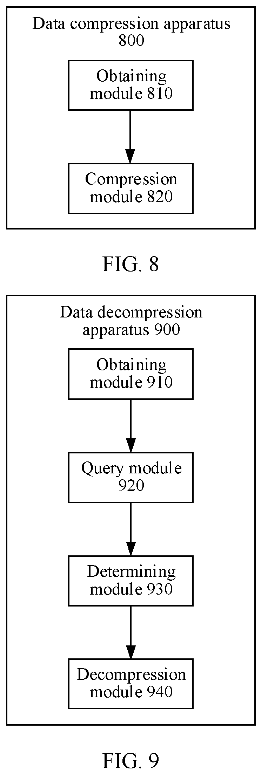

The foregoing describes in detail the data compression method provided in embodiments with reference to FIG. 1 to FIG. 6. The following describes a data compression apparatus provided in embodiments with reference to FIG. 8.

FIG. 8 is a diagram of a structure of a data compression apparatus according to this application. The data compression apparatus may be configured to implement functions of the processing device in the foregoing method embodiments. Therefore, beneficial effects of the foregoing method embodiments can also be implemented. In this embodiment, the data compression apparatus may be a module (for example, a chip) of the processing device.

As shown in FIG. 8, a data compression apparatus 800 includes an obtaining module 810 and a compression module 820. The data compression apparatus 800 is configured to implement functions in the method embodiments shown in FIG. 1 to FIG. 6.

The obtaining module 810 is configured to obtain second data corresponding to first data, where a storage structure of the second data is a tree structure, a bottom-layer node of the tree structure includes a root-child node and a leaf-child node that has an index relationship with the root-child node, and the first data includes data indicated by the root-child node and data indicated by the leaf-child node.

The compression module 820 is configured to compress the second data to obtain compressed data corresponding to the first data, where the compressed data includes the data indicated by the root-child node and compressed data indicated by the leaf-child node.

It should be noted that, in another embodiment, the obtaining module 810 may be configured to perform any step in a management method, and the compression module 820 may be configured to perform any step in the management method. Steps that the obtaining module 810 and the compression module 820 are responsible for implementing may be specified as required. The obtaining module 810 and the compression module 820 respectively implement different steps in the data compression method, to implement all functions of the data compression apparatus 800.

It should be noted that the processing device according to embodiments of this application may correspond to the data compression apparatus 800 in embodiments of this application, and may correspond to a corresponding body for performing the methods in FIG. 1 to FIG. 6 according to embodiments of this application. In addition, operations and/or functions of modules in the data compression apparatus 800 are separately used to implement corresponding procedures of the methods in the corresponding embodiments in FIG. 1 to FIG. 6. For brevity, details are not described herein again.

The foregoing describes in detail the data decompression method according to embodiments with reference to FIG. 7. The following describes a data decompression apparatus according to embodiments with reference to FIG. 9.

FIG. 9 is a diagram of a structure of a data decompression apparatus according to this application. The data decompression apparatus may be configured to implement functions of the processing device in the foregoing method embodiments. Therefore, beneficial effects of the foregoing method embodiments can also be implemented. In this embodiment, the data decompression apparatus may be a module (for example, a chip) of the processing device.

As shown in FIG. 9, a data decompression apparatus 900 includes an obtaining module 910, a query module 920, a determining module 930, and a decompression module 940. The data decompression apparatus 900 is configured to implement functions in the method embodiment shown in FIG. 7.

The obtaining module 910 is configured to obtain a data decompression request, where the data decompression request includes an identifier of first data.

The query module 920 is configured to query compressed data based on the identifier of the first data, where a storage structure of the compressed data is a tree structure, a bottom-layer node of the tree structure includes a root-child node and a leaf-child node that has an index relationship with the root-child node, and the compressed data includes data indicated by the root-child node and compressed data indicated by the leaf-child node.

The determining module 930 is configured to determine a target storage area that is in the compressed data and that matches the identifier of the first data, where the target storage area is a storage area of the leaf-child node.

The decompression module 940 is configured to decompress data in the target storage area, to obtain the first data.

It should be noted that, in another embodiment, the obtaining module 910 may be configured to perform any step in the management method, the query module 920 may be configured to perform any step in the management method, the determining module 930 may be configured to perform any step in the management method, and the decompression module 940 may be configured to perform any step in the management method. Steps that the obtaining module 910, the query module 920, the determining module 930, and the decompression module 940 are responsible for implementing may be specified as required. The obtaining module 910, the query module 920, the determining module 930, and the decompression module 940 respectively implement different steps in the data decompression method, to implement all functions of the data decompression apparatus 900.

It should be noted that the processing device according to embodiments of this application may correspond to the data decompression apparatus 900 in embodiments of this application, and may correspond to a corresponding body for performing the method in FIG. 7 according to embodiments of this application. In addition, operations and/or functions of modules in the data decompression apparatus 900 are separately used to implement corresponding procedures of the methods in the corresponding embodiments in FIG. 7. For brevity, details are not described herein again.

When the data compression apparatus or the data decompression apparatus implements, by using software, the data compression method or the data decompression method shown in any one of the foregoing accompanying drawings, the data compression apparatus and units of the data compression apparatus or the data decompression apparatus and units of the data decompression apparatus may also be software modules. The processor invokes the software module to implement the foregoing data compression method or data decompression method. The processor may be a CPU, an ASIC, or a programmable logic device (programmable logic device, PLD). The PLD may be a complex programmable logical device (complex programmable logical device, CPLD), a field programmable gate array (field programmable gate array, FPGA), a generic array logic (generic array logic, GAL), or any combination thereof.

For more detailed descriptions of the data compression apparatus or the data decompression apparatus, refer to related descriptions in embodiments shown in the foregoing accompanying drawings. Details are not described herein again. It may be understood that the data compression apparatus or the data decompression apparatus shown in the foregoing accompanying drawings is merely an example provided in this embodiment. The data compression apparatus or the data decompression apparatus may include more or fewer units based on different data types or compression manners. This is not limited in this application.

When the data compression apparatus or the data decompression apparatus is implemented by hardware, the hardware may be implemented by a processor or a chip. The chip includes an interface circuit and a control circuit. The interface circuit is configured to receive data from a device other than the processor and transmit the data to the control circuit, or send data from the control circuit to a device other than the processor.

The control circuit and the interface circuit are configured to implement, by using a logic circuit or by executing code instructions, the method according to any one of the possible implementations of the foregoing embodiments. For beneficial effects, refer to descriptions of any aspect of foregoing embodiments. Details are not described herein again.

It may be understood that the processor in embodiments of this application may be a CPU, an NPU, or a GPU, or may be another general-purpose processor, a digital signal processor (digital signal processor, DSP), an ASIC, an FPGA, or another programmable logic device, a transistor logic device, a hardware component, or any combination thereof. The general-purpose processor may be a microprocessor or may be any regular processor.

In addition, the data compression apparatus 800 shown in FIG. 8 and the data decompression apparatus 900 shown in FIG. 9 may alternatively be implemented by using a storage device, for example, the storage device 120 shown in FIG. 1, or a data storage system including a storage device.

The method steps in embodiments of this application may alternatively be implemented by a processor executing software instructions. The software instructions may include a corresponding software module. The software module may be stored in a RAM, a flash memory, a ROM, a PROM, an EPROM, an electrically erasable programmable read-only memory (electrically EPROM, EEPROM), a register, a hard disk, a removable hard disk, a CD-ROM, or any other form of storage medium well-known in the art. For example, a storage medium is coupled to a processor, so that the processor can read information from the storage medium and write information into the storage medium. Certainly, the storage medium may alternatively be a component of the processor. The processor and the storage medium may be disposed in an ASIC. In addition, the ASIC may be located in a communication device. Certainly, the processor and the storage medium may alternatively exist in the communication device as discrete components.

This application further provides a chip system. The chip system includes a processor, configured to implement functions of the storage device in the foregoing methods. In a possible design, the chip system further includes a storage, configured to store program instructions and/or data. The chip system may include a chip, or may include a chip and another discrete component.

An embodiment of this application further provides a computer program product including instructions. The computer program product may be software or a program product that includes the instructions and that can run on a compute device or be stored in any usable medium. When the computer program product runs on at least one compute device, the at least one compute device is enabled to perform the compression method or the decompression method.

An embodiment of this application further provides a computer-readable storage medium. The computer-readable storage medium may be any usable medium that can be stored in a compute device, or a data storage device like a data center including one or more usable media. The usable medium may be a magnetic medium (for example, a floppy disk, a hard disk, or a magnetic tape), an optical medium (for example, a DVD), a semiconductor medium (for example, a solid-state drive), or the like. The computer-readable storage medium includes instructions, and the instructions instruct a compute device to perform a compression method or a decompression method.

All or some of the foregoing embodiments may be implemented by software, hardware, firmware, or any combination thereof. When embodiments are implemented by software, all or some of embodiments may be implemented in a form of a computer program product. The computer program product includes one or more computer programs or instructions. When the computer programs or the instructions are loaded and executed on a computer, the procedures or functions in embodiments of this application are all or partially executed. The computer may be a general-purpose computer, a dedicated computer, a computer network, a network device, user equipment, or another programmable apparatus. The computer program or instructions may be stored in a computer-readable storage medium, or may be transmitted from a computer-readable storage medium to another computer-readable storage medium. For example, the computer program or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape, may be an optical medium, for example, a digital video disc (digital video disc, DVD), or may be a semiconductor medium, for example, a solid-state drive (solid-state drive, SSD).

In embodiments of this application, unless otherwise stated or there is a logic conflict, terms and/or descriptions between different embodiments are consistent and may be mutually referenced, and technical features in different embodiments may be combined based on an internal logical relationship thereof, to form a new embodiment. Various numbers in embodiments of this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes.

## Claims

1. A data compression method, wherein the method comprises:
obtaining second data corresponding to first data, wherein a storage structure of the second data is a tree structure, a bottom-layer node of the tree structure comprises a root-child node and a leaf-child node that has an index relationship with the root-child node, and the first data comprises data indicated by the root-child node and data indicated by the leaf-child node; and
compressing the second data to obtain compressed data corresponding to the first data, wherein the compressed data comprises the data indicated by the root-child node and compressed data indicated by the leaf-child node.

2. The method according to claim 1, wherein a storage area of the root-child node is used to store first child data that meets a condition, a storage area of the leaf-child node is used to store second child data that does not meet the condition, the condition indicates that an access metric of data is greater than or equal to a threshold, or an interval between identifiers of two adjacent pieces of data indicated by the root-child node is K plus 1, and K is an integer greater than or equal to 1.

3. The method according to claim 2, wherein the access metric comprises an access count or an access frequency, the first child data indicates hot data, and the second child data indicates cold data.

4. The method according to claim 2, wherein K satisfies the following formula: $K \left(K+X\right) \geq N ,$ wherein
X is a constant, and N is a data volume comprised in one bottom-layer node.

5. The method according to any one of claims 1 to 4, wherein a storage area of the bottom-layer node in the compressed data is further used to store a right boundary or left and right boundaries of each group of data indicated by the leaf-child node in the storage area of the leaf-child node, wherein
a left boundary of a first group of data indicates a minimum byte length from a start address of the storage area corresponding to the leaf-child node to a location at which the first group of data is stored, a right boundary of the first group of data indicates a maximum byte length from a start address of the storage area corresponding to the leaf-child node to a location at which the first group of data is stored, and the first group of data is any group of data indicated by the leaf-child node.

6. The method according to claim 5, wherein the data indicated by the root-child node indicates the right boundary or the left and right boundaries of each group of data.

7. The method according to any one of claims 1 to 6, wherein a data format of the first data is a key-value pair Key-Value, and the data indicated by the leaf-child node is sequentially stored in the storage area of the leaf-child node based on keys.

8. The method according to any one of claims 1 to 7, wherein the tree structure is a B+-Tree.

9. A data decompression method, wherein the method comprises:
obtaining a data decompression request, wherein the data decompression request comprises an identifier of first data;
querying compressed data based on the identifier of the first data, wherein a storage structure of the compressed data is a tree structure, a bottom-layer node of the tree structure comprises a root-child node and a leaf-child node that has an index relationship with the root-child node, and the compressed data comprises data indicated by the root-child node and compressed data indicated by the leaf-child node;
determining a target storage area that is in the compressed data and that matches the identifier of the first data, wherein the target storage area is a storage area of the leaf-child node; and
decompressing data in the target storage area, to obtain the first data.

10. The method according to claim 9, wherein a storage area of the bottom-layer node in the compressed data is further used to store a right boundary or left and right boundaries of each group of data indicated by the leaf-child node in the storage area of the leaf-child node, wherein
a left boundary of a first group of data indicates a minimum byte length from a start address of the storage area corresponding to the leaf-child node to a location at which the first group of data is stored, a right boundary of the first group of data indicates a maximum byte length from a start address of the storage area corresponding to the leaf-child node to a location at which the first group of data is stored, and the first group of data is any group of data indicated by the leaf-child node.

11. The method according to claim 10, wherein the data indicated by the root-child node indicates the right boundary or the left and right boundaries of each group of data.

12. The method according to claim 11, wherein the determining the target storage area that is in the compressed data and that matches the identifier of the first data comprises:
sequentially performing query from a root node of the compressed data to the bottom-layer node based on the identifier of the first data, wherein the first data or address information of the first data is stored in the storage area of the leaf-child node in the bottom-layer node; and
comparing the identifier of the first data with data in the root-child node, to determine a right boundary or left and right boundaries of a second group of data, wherein the second group of data comprises the first data, and the right boundary or the left and right boundaries of the second group of data indicate the target storage area.

13. The method according to claim 12, wherein the comparing the identifier of the first data with the data in the root-child node, and determining the right boundary or the left and right boundaries of the second group of data comprises:
determining a first identifier and/or a second identifier that are/is in identifiers of the data indicated by the root-child node and that meet/meets a first policy with the identifier of the first data, wherein the first policy indicates that the identifier of the first data is less than the first identifier, or the identifier of the first data is greater than the second identifier, or the identifier of the first data is greater than or equal to the first identifier and less than or equal to the second identifier, and the first identifier is less than the second identifier;
determining, from an index relationship, a second group of data in a leaf-child node corresponding to the first identifier and/or the second identifier; and
obtaining a right boundary or left and right boundaries of the second group of data in a storage area of the leaf-child node.

14. The method according to any one of claims 9 to 13, wherein a storage area of the root-child node is used to store first child data that meets a condition, the storage area of the leaf-child node is used to store second child data that does not meet the condition, the first data comprises the first child data and the second child data, and the condition indicates that an access metric of data is greater than or equal to a threshold, or an interval between identifiers of two adjacent pieces of data indicated by the root-child node is K plus 1, and K is an integer greater than or equal to 1.

15. The method according to claim 14, wherein the access metric comprises an access count or an access frequency, the first child data indicates hot data, and the second child data indicates cold data.

16. The method according to claim 14, wherein K satisfies the following formula: $K \left(K+X\right) \geq N ,$ wherein
X is a constant, and N is a data volume comprised in one bottom-layer node.

17. The method according to any one of claims 9 to 16, wherein a data format of the first data is a key-value pair Key-Value, and the data indicated by the leaf-child node is sequentially stored in the storage area of the leaf-child node based on keys.

18. The method according to any one of claims 9 to 17, wherein the tree structure comprises a B+-Tree.

19. A data compression apparatus, wherein the apparatus comprises:
an obtaining module, configured to obtain second data corresponding to first data, wherein a storage structure of the second data is a tree structure, a bottom-layer node of the tree structure comprises a root-child node and a leaf-child node that has an index relationship with the root-child node, and the first data comprises data indicated by the root-child node and data indicated by the leaf-child node; and
a compression module, configured to compress the second data to obtain compressed data corresponding to the first data, wherein the compressed data comprises the data indicated by the root-child node and compressed data indicated by the leaf-child node.

20. The apparatus according to claim 19, wherein a storage area of the root-child node is used to store first child data that meets a condition, a storage area of the leaf-child node is used to store second child data that does not meet the condition, the condition indicates that an access metric of data is greater than or equal to a threshold, or an interval of between identifiers of two adjacent pieces of data indicated by the root-child node is K plus 1, and K is an integer greater than or equal to 1.

21. The apparatus according to claim 20, wherein the access metric comprises an access count or an access frequency, the first child data indicates hot data, and the second child data indicates cold data.

22. The apparatus according to claim 20, wherein K satisfies the following formula: $K \left(K+X\right) \geq N ,$ wherein
X is a constant, and N is a data volume comprised in one bottom-layer node.

23. The apparatus according to any one of claims 19 to 22, wherein a storage area of the bottom-layer node in the compressed data is further used to store a right boundary or left and right boundaries of each group of data indicated by the leaf-child node in the storage area of the leaf-child node, wherein
a left boundary of a first group of data indicates a minimum byte length from a start address of the storage area corresponding to the leaf-child node to a location at which the first group of data is stored, a right boundary of the first group of data indicates a maximum byte length from a start address of the storage area corresponding to the leaf-child node to a location at which the first group of data is stored, and the first group of data is any group of data indicated by the leaf-child node.

24. The apparatus according to claim 23, wherein the data indicated by the root-child node indicates the right boundary or the left and right boundaries of each group of data.

25. The apparatus according to any one of claims 19 to 24, wherein a data format of the first data is a key-value pair Key-Value, and the data indicated by the leaf-child node is sequentially stored in the storage area of the leaf-child node based on keys.

26. The apparatus according to any one of claims 19 to 25, wherein the tree structure is a B+-Tree.

27. A data decompression apparatus, wherein the apparatus comprises:
an obtaining module, configured to obtain a data decompression request, wherein the data decompression request comprises an identifier of first data;
a query module, configured to query compressed data based on the identifier of the first data, wherein a storage structure of the compressed data is a tree structure, a bottom-layer node of the tree structure comprises a root-child node and a leaf-child node that has an index relationship with the root-child node, and the compressed data comprises data indicated by the root-child node and compressed data indicated by the leaf-child node;
a determining module, configured to determine a target storage area that is in the compressed data and that matches the identifier of the first data, wherein the target storage area is a storage area of the leaf-child node; and
a decompression module, configured to decompress data in the target storage area, to obtain the first data.

28. The apparatus according to claim 27, wherein a storage area of the bottom-layer node in the compressed data is further used to store a right boundary or left and right boundaries of each group of data indicated by the leaf-child node in the storage area of the leaf-child node, wherein
a left boundary of a first group of data indicates a minimum byte length from a start address of the storage area corresponding to the leaf-child node to a location at which the first group of data is stored, a right boundary of the first group of data indicates a maximum byte length from a start address of the storage area corresponding to the leaf-child node to a location at which the first group of data is stored, and the first group of data is any group of data indicated by the leaf-child node.

29. The apparatus according to claim 28, wherein the data indicated by the root-child node indicates the right boundary or the left and right boundaries of each group of data.

30. The apparatus according to claim 29, wherein the determining the target storage area that is in the compressed data and that matches the identifier of the first data comprises:
sequentially performing querying from a root node of the compressed data to the bottom-layer node based on the identifier of the first data, wherein the first data or address information of the first data is stored in the storage area of the leaf-child node in the bottom-layer node; and
comparing the identifier of the first data with data in the root-child node, and determining a right boundary or left and right boundaries of a second group of data, wherein the second group of data comprises the first data, and the right boundary or the left and right boundaries of the second group of data indicates the target storage area.

31. The apparatus according to claim 30, wherein the comparing the identifier of the first data with the data in the root-child node, and determining the right boundary or the left and right boundaries of the second group of data comprises:
determining a first identifier and/or a second identifier that are/is in identifiers of the data indicated by the root-child node and that meet/meets a first policy with the identifier of the first data, wherein the first policy indicates that the identifier of the first data is less than the first identifier, or the identifier of the first data is greater than the second identifier, or the identifier of the first data is greater than or equal to the first identifier and less than or equal to the second identifier, and the first identifier is less than the second identifier;
determining, from an index relationship, a second group of data in a leaf-child node corresponding to the first identifier and/or the second identifier; and
obtaining a right boundary or left and right boundaries of the second group of data in a storage area of the leaf-child node.

32. The apparatus according to any one of claims 27 to 31, wherein a storage area of the root-child node is used to store first child data that meets a condition, a storage area of the leaf-child node is used to store second child data that does not meet the condition, the first data comprises the first child data and the second child data, and the condition indicates that an access metric of data is greater than or equal to a threshold, or an interval between identifiers of two adjacent pieces of data indicated by the root-child node is K plus 1, and k is an integer greater than or equal to 1.

33. The apparatus according to claim 32, wherein the access metric comprises an access count or an access frequency, the first child data indicates hot data, and the second child data indicates cold data.

34. The apparatus according to claim 32, wherein K satisfies the following formula: $K \left(K+X\right) \geq N ,$ wherein
X is a constant, and N is a data volume comprised in one bottom-layer node.

35. The apparatus according to any one of claims 27 to 34, wherein a data format of the first data is a key-value pair Key-Value, and the data indicated by the leaf-child node is sequentially stored in the storage area of the leaf-child node based on keys.

36. The apparatus according to any one of claims 27 to 35, wherein the tree structure comprises a B+-Tree.

37. A computer device, comprising a storage and a processor, wherein the storage is configured to store computer instructions, and when the processor executes the computer instructions, the method according to any one of claims 1 to 18 is implemented.

38. A computer-readable storage medium, wherein the storage medium stores a computer program or instructions, and when the computer program or the instructions are executed by a processing device, the method according to any one of claims 1 to 18 is implemented.

39. A computer program product, comprising a computer program or instructions, wherein when the computer program or the instructions are executed by a processing device, the method according to any one of claims 1 to 18 is implemented.
